(19) **Europäisches Patentamt**

**European Patent Office**

**Office européen des brevets**

(11) **EP 0 887 929 B1**

(12) **FASCICULE DE BREVET EUROPEEN**

(45) Date de publication et mention
de la délivrance du brevet:
**25.02.2004 Bulletin 2004/09**

(51) Int Cl.⁷: **H03K 3/33**, H03K 3/57

(21) Numéro de dépôt: **98401526.3**

(22) Date de dépôt: **22.06.1998**

(54) **Commutateur ultra-rapide, à haute fréquence de recurrence**

Extrem schneller Schalter mit hoher Folgefrequenz

Ultra-fast switch with high recurrence frequency

(84) Etats contractants désignés:
**CH DE GB IT LI**

(30) Priorité: **24.06.1997 FR 9707834**

(43) Date de publication de la demande:
**30.12.1998 Bulletin 1998/53**

(73) Titulaire: **COMMISSARIAT A L'ENERGIE ATOMIQUE**
**75015 Paris (FR)**

(72) Inventeurs:
• **Chatroux, Daniel**
**26200 Montélimar (FR)**
• **Nouvel, Philippe**
**26200 Montélimar (FR)**
• **Vellard, Jean-François**
**16100 Cognac (FR)**

(74) Mandataire: **Moutard, Pascal Jean et al**
**Brevalex**
**3, Rue du Docteur Lancereaux**
**75008 Paris (FR)**

(56) Documents cités:
**EP-A- 0 716 507          DE-B- 1 095 384**
**US-A- 3 832 568**

**Description**

Domaine technique et art antérieur

L'invention définie dans la revendication concerne un commutateur ultra-rapide à haute fréquence de récurrence. Il s'agit en particulier d'un commutateur de puissance pour générateur d'impulsions ultra-rapides (temps de commutation de l'ordre d'une nanoseconde) et à fréquence de récurrence élevée (jusqu'à plusieurs dizaines de kilohertz). De tels commutateurs trouvent application dans le domaine des alimentations pulsées, en électronique de puissance.

Pour réaliser des commutateurs se mettant en conduction en une nanoseconde ou moins, les solutions classiques consistent à utiliser soit le régime d'avalanche dans une diode ou dans un transistor bipolaire, soit des transistors MOSFETs dont la grille est commandée par des signaux de forte amplitude en tension.

Dans la première solution (avalanche dans les semi-conducteurs) on applique une tension élevée entre les bornes principales d'un transistor ou d'une diode, jusqu'à effondrement de la tension entre ces bornes par mise en conduction par le régime d'avalanche. Cette première solution est décrite par exemple dans l'article de R.J. Baker intitulé "High voltage pulse generation using current mode second breakdown in a bipolar junction transistor", paru dans Rev. Sci. Instrum. 62(4), April 1991, 1031-1036, ou bien dans l'article du même auteur intitulé "Nanosecond switching using power MOSFETs" paru dans Rev. Sci. Instrum. 61(8), August 1990, 2211-2213; ces deux documents concernent l'utilisation de transistors bipolaires. L'utilisation de diodes est décrite dans l'article de D.M. Benzel et al. intitulé "1000V, 300ps pulse-generation circuit using silicon avalanche devices", paru dans Rev. Sci. Instrum. 56(7), July 1985, 1456-1458.

La seconde solution (utilisation de MOSFETs) est décrite par exemple dans l'article de R.J. Baker intitulé "Nanosecond switching using power MOSFETs" déjà cité ci-dessus ainsi que dans l'article de R.J. Baker et al., intitulé "A 500V nanosecond pulse generator using cascade-connected power MOSFETs", paru dans Meas. Sci. Technol. 3 (1992), 775-777.

Cette seconde solution consiste à commander des transistors MOSFETs par des tensions de grille d'amplitude importante (les articles ci-dessus donnent 0V/40V ou ±20V), ce qui provoque leur mise en conduction rapide (en 3ns et 2ns respectivement d'après les articles cités ci-dessus). Le circuit de commande de grille des transistors MOSFETs peut aussi utiliser un transistor bipolaire mis en conduction par avalanche à partir d'une tension de 200V, comme décrit dans l'article de R.J. Baker intitulé "Nanosecond switching using power MOSFETs" déjà cité ci-dessus.

Exposé de l'invention

Les principaux problèmes posés par les dispositifs connus concernent la fiabilité des composants. En effet, le phénomène d'avalanche provoque une fatigue importante des transistors ou des diodes; ce qui diminue notablement leur durée de vie. D'autre part, la durée de vie des transistors MOSFETs diminue d'autant plus qu'on leur applique des signaux de grille d'amplitude élevée.

Il est de plus préférable d'utiliser des composants standards, qui possèdent les avantages d'être peu chers, faciles à approvisionner, et parfaitement connus.

La tension d'avalanche n'est ni spécifiée ni garantie par les constructeurs, et les montages utilisant les composants en régime d'avalanche manquent de reproductibilité lors des productions en série. L'utilisation du régime d'avalanche interdit également de fonctionner à des fréquences de récurrence importantes sous peine de destruction des composants du fait de l'énergie dissipée, ce qui limite le champ d'application des montages utilisant ce phénomène.

Les transistors MOSFETs sont les composants privilégiés pour la réalisation de commutateurs rapides, en raison de leur commande en tension par la grille et de la rapidité de leur mise en conduction. Cependant, lorsque l'on utilise un transistor MOSFET commandé par des tensions de grille compatibles avec une durée de vie élevée, les temps de commutation se trouvent limités en raison des inductances propres du boîtier, qui limitent le courant de grille lors de la décharge des capacités parasites du transistor (phénomène dit de palier MILLER). Pour des tensions de grille 0V/15V, on obtient des commutations en 5ns pour une tension drain-source de 500V, avec des transistors MOSFETs "IRF 840 Low Charge" qui sont les composants standards les plus rapides.

L'invention a donc pour objet un commutateur ultra-rapide, comportant :

- un transistor MOSFET,
- une diode rapide à recouvrement inverse dur,
- un condensateur situé entre la diode et le transistor,
- des moyens pour appliquer un courant direct de polarisation de la diode égal au plus au 1/3 du courant inverse pouvant circuler lorsque le transistor est fermé.

L'invention a également pour objet un commutateur ultra-rapide, comportant :

- une matrice de transistors MOSFET,
- une matrice de diodes rapides,
- un condensateur, situé entre les deux matrices,
- des moyens pour appliquer un courant direct de polarisation des diodes égal au plus au 1/3 du courant inverse pouvant circuler lorsque le transistor est fermé.

L'un ou l'autre de ces dispositifs est réalisable avec des composants aisément disponibles et ne nécessite qu'un courant direct faible par rapport au courant inverse. Le courant direct permet d'injecter des porteurs dans la diode (ou dans la matrice de diodes), qui sont déchargés très rapidement avec le courant inverse. Ces dispositifs permettent d'obtenir des commutations très rapides tout en appliquant aux transistors MOSFET des tensions de grille compatibles avec une durée de vie élevée de ces composants.

Le document US-A-3 832 568 divulgue un circuit qui utilise une diode rapide à recouvrement inverse dur.

Brève description des figures

De toute façon, les caractéristiques et avantages de l'invention apparaîtront mieux à la lumière de la description qui va suivre. Cette description porte sur les exemples de réalisation, donnés à titre explicatif et non limitatif, en se référant à des dessins annexés sur lesquels :

- la figure 1 est un schéma d'un dispositif selon l'invention,
- les figures 2A et 2B sont des exemples de réalisation de sources de courant,
- les figures 3A à 3C illustrent des étapes du fonctionnement d'un dispositif selon l'invention,
- la figure 4 représente l'évolution temporelle du courant et de la tension dans une diode d'un dispositif selon l'invention,
- les figures 5 et 6 représentent des réalisations de matrices de diodes,
- la figure 7 représente une réalisation de l'invention avec matrice de diodes et matrice de transistors MOSFET,
- la figure 8 représente un pont onduleur.

Description détaillée de modes de réalisation de l'invention

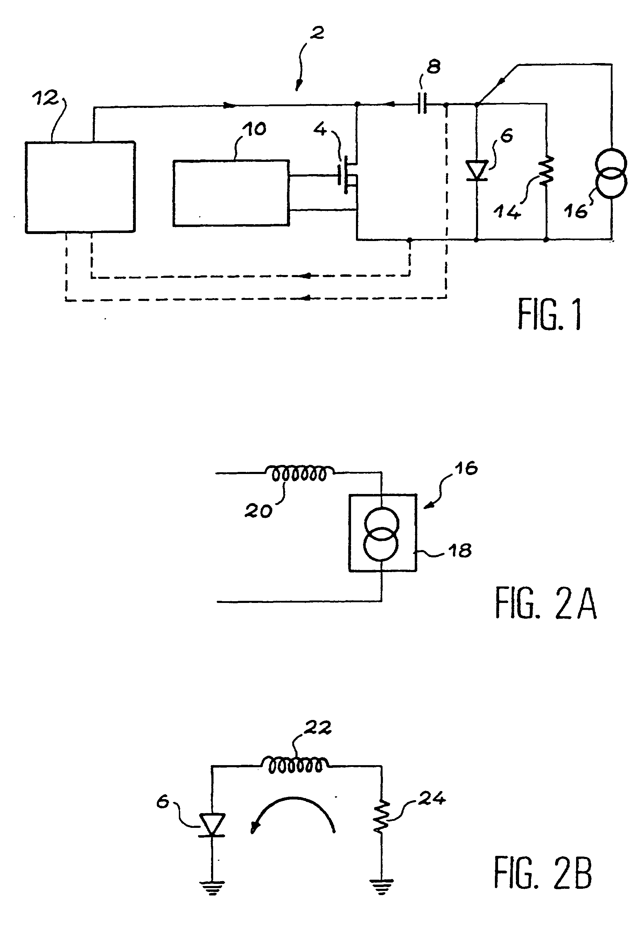

La figure 1 représente un circuit mettant en oeuvre l'invention.

Une cellule de commutation 2 comprend notamment un transistor MOSFET 4 standard (par exemple de type IRF 840 LC) et une diode 6 rapide et standard (de type MUR 840, par exemple) dont on utilise le temps de recouvrement inverse. Une diode "rapide" présente un temps de recouvrement inverse par exemple d'au plus 100 ns.

De plus, la diode est du type à recouvrement inverse dur ("hard-recovery diode").

Un condensateur 8, situé entre le transistor 4 et la diode 6, permet d'appliquer une tension négative aux bornes de la diode lors de la mise en conduction du transistor MOSFET.

Un dispositif 10 de commande (par exemple 0V/15V) du transistor MOSFET 4 peut classiquement être réalisée par un circuit intégré, par exemple de type TSC 4426, qui est un des circuits spécialisés pour la commande des transistors MOSFETs. Il génère un signal 0/15 V à front raide de 10 ns à partir d'un signal 0/5 V issu par exemple d'un circuit en logique TTL. Pour générer les fronts raides, il est capable de fournir ou d'absorber des courants de 3A pour charger ou décharger les capacités internes du transistor MOS.

La cellule de commutation est mise sous tension AV par une alimentation en tension 12. La référence 14 désigne une résistance de charge.

La diode est polarisée par un courant direct $I_1$ provenant d'une source de courant 16. Le transistor 4 MOS choisi détermine le courant inverse $I_2$ pouvant circuler. On choisit $I_1$, de manière à ce que $I_1 < I_2/3$ ou $I_2/10$.

La source de courant 16 produisant le courant direct dans la diode peut être réalisée par une alimentation 18 de courant sous basse tension (régulation linéaire) et une inductance 20 en série, comme illustré sur la figure 2A.

A haute fréquence de récurrence (quelques dizaines de kilohertz), cette source de courant 16 peut avantageusement être réalisée par un circuit composé d'une inductance 22 et d'une résistance 24 en série, le tout placé parallèlement à la diode 6 (figure 2B). En effet, à haute fréquence de récurrence, la tension moyenne aux bornes de la diode atteint une valeur suffisante (environ 2V) pour provoquer la circulation d'un courant permanent, ajustable par une résistance.

Le dispositif fonctionne de la manière suivante, expliquée en liaison avec les figures 3A-3C qui représentent des schémas équivalents du dispositif de la figure 1 et où des références numériques identiques y désignent des mêmes éléments.

A titre d'exemple, l'inductance 20 vaut par exemple 1mH, la capacité 8 vaut 100 nF et le circuit est alimenté par une tension de 500V qui débite sur une résistance 13 de 10 KΩ. Pour la diode, on peut choisir par exemple une diode ultra-rapide dont le recouvrement est très peu progressif : une diode pouvant être utilisée est la MUR 840 de Motorola.

Lorsque le transistor 4 est ouvert (figure 3A), le potentiel au point A est celui de la source de tension (500V dans l'exemple) et la diode est polarisée par un courant direct $I_1$ faible (de 0,4 à 0,8 A par exemple) provenant de la source de courant 18, 20.

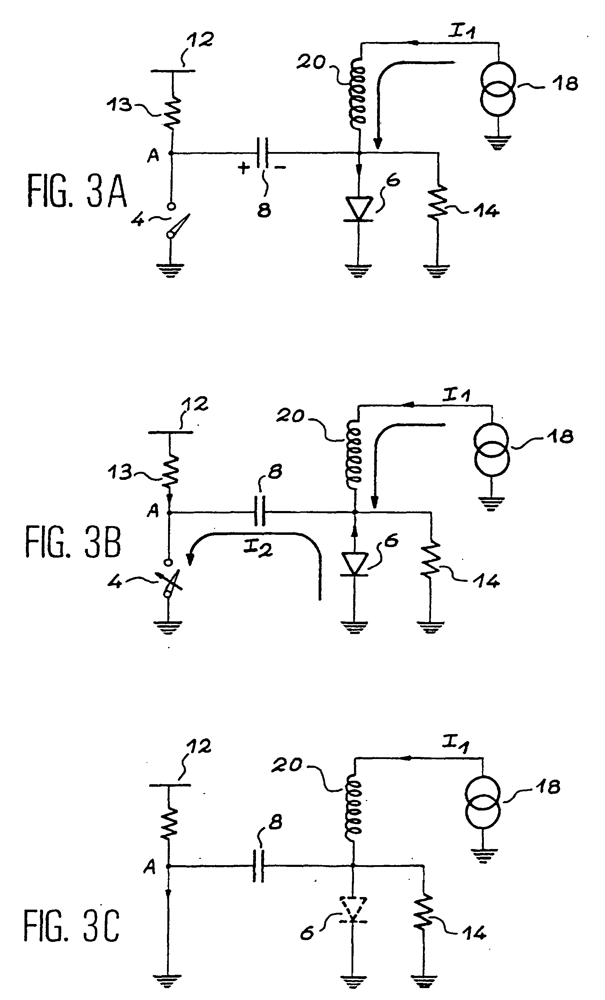

Lorsque l'on envoie l'ordre de fermeture au transistor MOSFET 4 (figure 3B), sa tension de grille monte à une certaine tension (15V dans l'exemple) pendant la phase de recouvrement inverse durant laquelle la diode conduit le courant inverse $I_2$.

La diode laisse passer ce courant inverse $I_2$, (par exemple d'amplitude environ 40A), pendant un temps de quelques dizaines de nanosecondes, appelé temps de recouvrement inverse ($t_{rr}$). Puis elle bloque violemment le courant (figure 3C).

Lorsque la diode se bloque, elle provoque un dI/dt important. Le courant $I_2$ charge très rapidement. les capacités parasites de la diode 6. On observe alors un front de tension de l'ordre de la nanoseconde pour la tension d'alimentation ΔV.

L'avantage du dispositif selon l'invention est de ne nécessiter qu'un courant direct faible par rapport au courant inverse ($I_1 < I_2/3$ ou $I_2/10$). Le courant direct de polarisation permet d'injecter des porteurs en nombre suffisant dans la diode. Pour cela, il est maintenu pendant environ au moins une microseconde, ou plus (par exemple : 10 μs). Lors de la phase d'inversion, ces porteurs sont déchargés très rapidement.

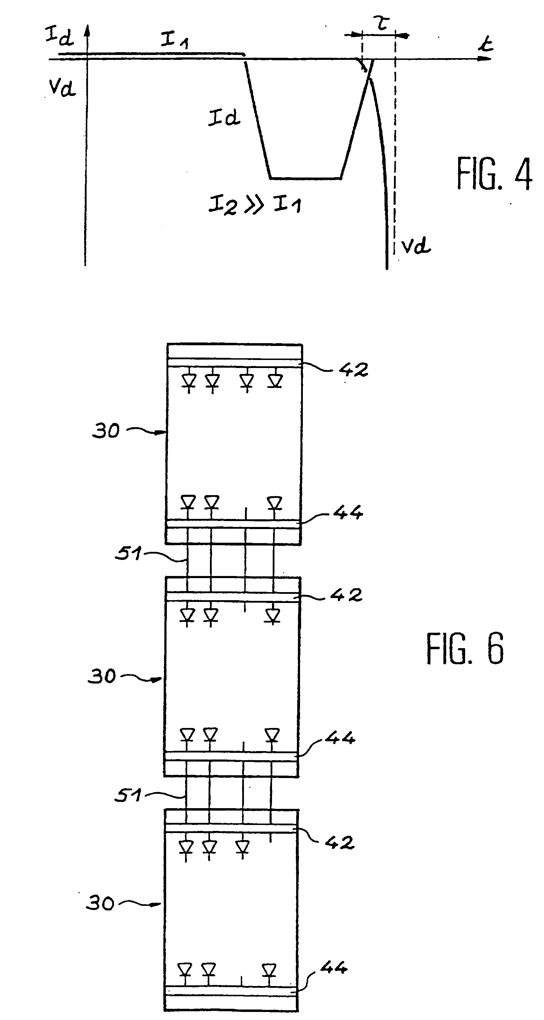

Utiliser le recouvrement inverse avec un autre type de diode (par exemple, diode de redressement à avalanche contrôlée), en lui appliquant des pulses de courant, direct puis indirect, de même amplitude et de durée inférieure à la durée de vie des porteurs, nécessiterait un montage complexe et ne permettrait pas de limiter l'intensité du courant direct. Le dispositif selon la présente invention permet d'une part une réalisation plus aisée du montage et, d'autre part, d'éviter une dissipation d'énergie importante dans la diode, et donc de limiter son échauffement. L'allure des signaux obtenus est alors tout à fait particulière, comme ceci peut se voir d'après la figure 4 qui représente l'évolution temporelle des signaux (courant $I_d$ et tension $V_d$) aux bornes de la diode. La durée τ pendant laquelle $V_d$ varie fortement est de l'ordre de 1ns.

Le tableau I suivant rassemble des caractéristiques des composants choisis pour la réalisation d'un commutateur alimenté sous 500V, pouvant commuter en 1ns et fonctionnant à 20 kHz.

TABLEAU I

| | |
|---|---|
| Transistor MOSFET | IRF 840 LC (International Rectifier) |
| Diode | MUR 840 (Motorola) |
| Capacité C | 100 nF |
| Inductance La | 1 mH |

Pour la réalisation de générateurs de plus forte tension ou de plus fort courant, le transistor MOSFET 4 peut avantageusement être remplacé par une matrice de transistors MOSFETs (comme décrit dans la demande EP-716 507 ou dans la demande FR-95 15546) et les diodes par une matrice de diodes (comme décrit dans la demande FR-95 15545).

Une matrice 30 de diodes comprend, comme illustré sur la figure 5, une pluralité d'étages 34 montés en série.

Chaque étage 34 comprend une pluralité de diodes élémentaires 32 qui sont montées en parallèle.

A titre purement indicatif et nullement limitatif, les diodes élémentaires 32 peuvent être des diodes de puissance commercialisées par la société Motorola sous la référence MUR 840.

Ces diodes commercialement disponibles présentent l'avantage de bien supporter le régime d'avalanche et d'être rapides.

Dans la matrice 30, les diodes sont associées en série/parallèle sans réseau d'équilibrage statique ou dynamique.

Ceci est possible puisque les diodes choisies supportent bien le régime d'avalanche.

La matrice 30 est formée sur un support électriquement isolant 36.

Il s'agit d'un circuit imprimé sur lequel les diodes élémentaires sont donc implantées.

Comme on le voit sur la figure 5, des pistes électriquement conductrices 38, parallèles les unes aux autres, sont formées sur le circuit imprimé 36 et permettent le montage en parallèle des diodes élémentaires dans chaque étage 34.

Plus précisément, on voit que, dans chaque étage, les anodes des diodes sont reliées les unes aux autres par une telle piste et les cathodes de ces diodes sont également reliées les unes aux autres par une telle piste.

On notera qu'une autre piste conductrice 42, qui est parallèle aux pistes 38 et formée à une extrémité de la matrice pour relier toutes les anodes des diodes du premier étage de la matrice entre elles, a une largeur supérieure à celle des pistes 38.

Cette piste 42 constitue la connexion d'anode de la diode de puissance de la figure 5.

De même, une autre piste conductrice 44, qui est parallèle aux pistes 38 et formée à l'autre extrémité de la matrice pour relier toutes les cathodes des diodes du dernier étage de la matrice entre elles, a une largeur supérieure à celle des pistes 38 (qui sont comprises entre ces pistes 42 et 44).

Cette piste 44 constitue la connexion de cathode de la diode de puissance de la figure 5.

On voit également sur la figure 5 d'autres pistes électriquement conductrices 46 qui sont formées sur le circuit imprimé 36 et qui sont perpendiculaires aux pistes 38, 42 et 44.

Ces pistes 46 permettent à chaque diode élémentaire 32 d'être reliée aux pistes parallèles précédentes qui lui sont associées.

Ces pistes 46 correspondent respectivement aux colonnes de la matrice 30 tandis que les pistes 38, 42 et 44 correspondent respectivement aux lignes de la matrice 30.

On précise que la largeur des pistes 38, 42, 44 et 46 est au moins égale à 4 mm.

Ceci permet le passage d'un courant électrique important dans les diodes élémentaires 32, sans échauffement excessif de celles-ci, et conduit également à de faibles inductances parasites au niveau des connexions entre diodes pour permettre l'établissement rapide du courant électrique dans la matrice.

Les portions de pistes 46 respectivement associées aux diodes élémentaires 32 ont la même longueur 1.

Les diodes élémentaires ont donc des inductances de câblage identiques.

On réalise ainsi l'équilibrage des courants électriques des diodes de la matrice 30.

On voit sur la figure 5 que toutes les pistes 38, 42 et 44 s'étendent d'un côté à l'autre du circuit imprimé 36.

Dans l'exemple représenté, ce circuit imprimé est de forme rectangulaire et ces pistes s'étendent suivant toute la largeur L de ce circuit imprimé 36.

Ceci permet d'obtenir une répartition homogène du courant électrique entre les différentes diodes montées en parallèle dans chaque étage.

Le montage en série des étages 34 les uns avec les autres diminue les risques d'amorçage entre étage à la surface du circuit imprimé 36 et améliore le synchronisme d'apparition des courants entre les différentes branches parallèles de la matrice.

On améliore ainsi, en effet, la répartition de l'inductance de câblage.

On a par exemple réalisé une matrice de diodes de type MUR 840 à 15 lignes (et donc 15 étages) et 10 colonnes.

Une telle matrice constitue une diode haute tension rapide dont les caractéristiques sont les suivantes:

$$V_{rrm} = 6 \text{ kV}$$

$$I_m = 80 \text{ A}$$

$$t_{rr} = 35 \text{ ns}$$

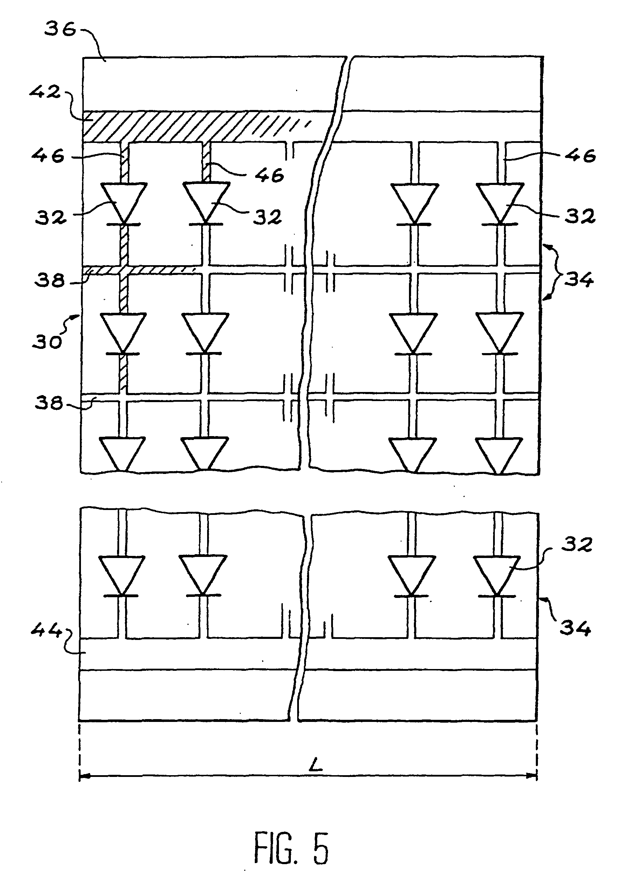

La figure 6 illustre schématiquement une autre diode de puissance conforme à l'invention.

Dans le cas de la figure 6, cette diode de puissance est constituée par la mise en série, au moyen de conducteurs électriques 51, d'une pluralité de matrices 30 du genre de celles de la figure 5 (trois matrices dans l'exemple représenté).

On peut par exemple connecter plusieurs matrices de diodes de type MUR 840 dont les caractéristiques ont été données ci-dessus afin de réaliser, par exemple, une diode de puissance 30 kV/80 A moyen/1000 A crête.

On a utilisé une telle diode de puissance en série avec un interrupteur de puissance 5 kV/1000 A crête réalisé à partir de transistors MOS, du type décrit dans EP-716 507, ou dans la demande FR-95 15546.

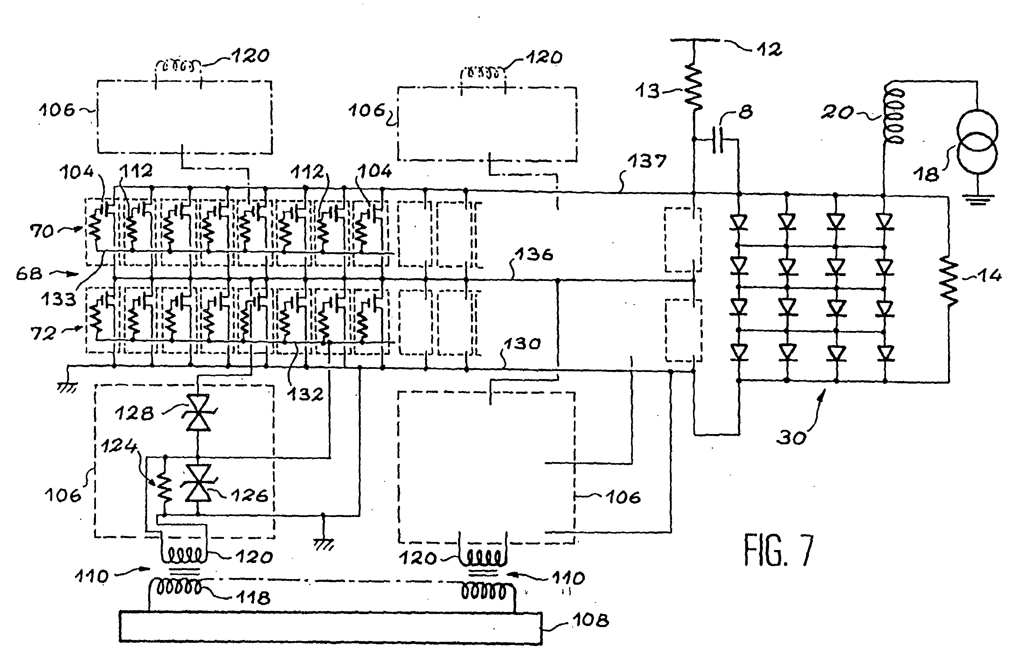

La figure 7 illustre schématiquement comment une matrice 30 de diodes, du type de celles qui viennent d'être décrites, peut être associée à une matrice 68 de transistors MOSFET 104.

La matrice de transistors constitue en fait un commutateur de puissance, capable de supporter plusieurs kilovolts et de commuter plusieurs milliers d'ampères.

Les vitesses de commutation de ce commutateur sont typiquement de l'ordre d'une quinzaine de nanosecondes.

Les transistors 104 sont par exemple du type IRF 840LC.

La matrice 68 a M lignes ou rangées et N colonnes.

Dans l'exemple représenté, le nombre M est égal à 2 (lignes 70, 72) tandis que le nombre N est égal à 24.

Les M lignes sont constituées de transistors 104 montés en parallèle tandis que les N colonnes sont constituées de transistor 104 montés en série.

La tenue en tension du commutateur de la figure 7 et donc N fois la tension maximale de rupture d'un transistor (Nx500 V avec des transistors du type IRF 840LC).

Le courant impulsionnel maximum que l'on peut obtenir est égal à M fois l'intensité supportable par un transistor (Mx40 A avec des transistors du type IRF 840LC).

Chaque transistor 104 est muni d'une résistance de grille 112. Celle-ci sert à la synchronisation des ordres de commande au niveau des transistors. Elle constitue une impédance de grille permettant d'obtenir des courants de commande distribués de façon uniforme entre les différents transistors.

Tous les drains des transistors 104 de la ligne 70 sont reliés les uns aux autres par une même ligne électrique 137 appelée "ligne de drain".

Toutes les grilles des transistors 104 sont reliées les unes aux autres par une même ligne électrique 133 appelée "ligne de grille".

Toutes les sources des transistors 104 de la ligne 70 sont reliées les unes aux autres par une même ligne électrique 136 appelée "ligne de source".

Dans la ligne 72 de la matrice 68, tous les drains des transistors sont reliés les uns aux autres par une même ligne de drain qui est confondue avec la ligne de source 136 relative à la ligne 70 de la matrice 68.

Toutes les grilles des transistors de la ligne 72 sont reliées les uns aux autres par une même ligne de grille 132 et toutes les sources de ces transistors de la ligne 72 sont reliées les unes aux autres par une même ligne de source 130.

On voit également sur cette figure 7 que les lignes 70 et 72 de transistor sont reliées en série.

Chacune des lignes 70 et 72 de la matrice 68 est divisée en trois groupes comprenant chacun huit transistors, dont deux groupes sont représentés sur la figure 7.

Dans la matrice 68, la répartition en groupes de transistors permet une bonne distribution des courants de commande et donc une commande simultanée de l'ensemble des transistors.

Pour la commande des transistors de la matrice 68, chaque groupe de transistor est associé à un dispositif de commande 106, lui-même associé à un transformateur d'impulsions 110, à un circuit primaire 118 et à un circuit secondaire 120.

On voit également, sur la figure 7, des moyens 108 de génération d'impulsions, qui sont couplés, par les transformateurs 110, aux dispositifs de commande 106.

De préférence, on utilise des transformateurs d'impulsions à noyau torique, chaque circuit secondaire comprenant une seule spire, chaque circuit primaire comprenant une seule spire, ces spires des circuits primaires des transformateurs 110 étant constituées par un même câble de commande.

Chaque dispositif de commande 106 comprend:

- des moyens 124 d'amortissement de la tension due à la démagnétisation du transformateur 110 correspondant,
- des moyens 126 d'écrêtage bidirectionnel de tension, et
- des moyens 128 d'écrêtage monodirectionnel de tension.

Comme on le voit sur la figure 7 les extrémités de la spire 120 du circuit secondaire du transformateur 110 sont respectivement reliées à la ligne de source 130 et à la ligne de grille 32.

Les moyens d'amortissement 124 sont par exemple constitués par une résistance électrique de quelques ohms, qui est montée aux bornes de la spire 120 du transformateur 110.

Les moyens 126 d'écrêtage bidirectionnel de tension sont, par exemple, constitués par une diode Zener bidirectionnelle 126 dont les bornes sont connectées respectivement à la ligne de source 130 et la ligne de grille 132.

Les moyens 128 d'écrêtage monodirectionnel de tension sont, par exemple constitués par une autre diode Zener bidirectionnelle 128 qui est montée entre la ligne de grille 132 et la ligne de drain 136.

L'association des moyens d'amortissement 124, des moyens d'écrêtage bidirectionnel 126 et des moyens d'écrêtage monodirectionnel 128 à chaque transformateur d'impulsion 110 conduit à des dispositifs de commande 106 d'une grande simplicité qui permet une réalisation industrielle et peu coûteuse du commutateur sur un circuit imprimé.

La structure des dispositifs de commande 106 permet également de n'utiliser qu'un seul câble de commande pour la mise en conduction et le blocage des transistors, comme expliqué dans FR-95 15546.

Dans ce dispositif, l'ordre de mise en conduction est une impulsion de courant positive fournie par le circuit primaire du transformateur 110, et transmise par un câble 118, afin de charger les grilles des transistors 104 à travers les résistances électriques 112 (impédances d'entrée).

L'ordre de blocage, qui est ensuite donné, est une impulsion de courant en sens contraire, donc négative, afin de décharger ces grilles et donc de forcer le blocage des transistors 104 du commutateur.

Ces deux impulsions de courant (impulsion ON puis impulsion OFF), dans le câble 118, peuvent être fournies par un pont onduleur.

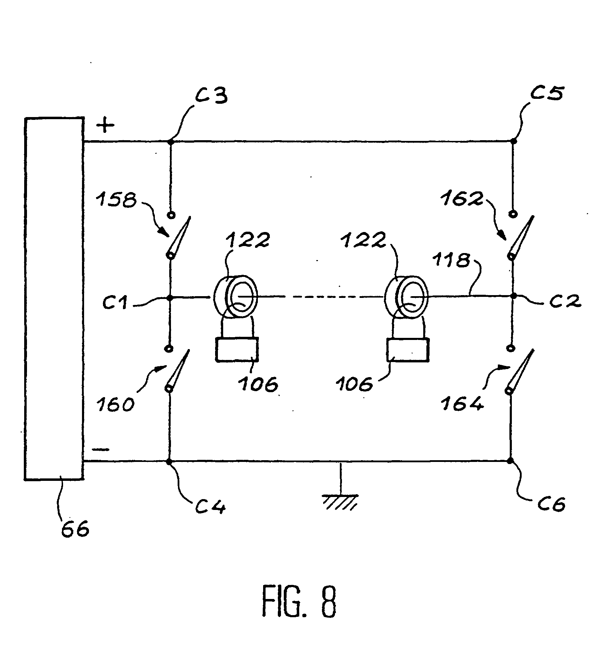

Un tel pont est représenté schématiquement sur la figure 8. Ce pont onduleur comprend quatre interrupteurs 158, 160, 162 et 164.

Les interrupteurs 158 et 160 ont une borne commune notée C1.

Les interrupteurs 162 et 164 ont une borne commune notée C2.

Les autres bornes des interrupteurs 158, 160, 162 et 164 ont respectivement les références C3, C4, C5 et C6.

Les extrémités du câble de commande 18 sont connectées aux bornes C1 et C2, comme on le voit sur la figure 8.

Les moyens 108 de génération d'impulsions sont munis d'une alimentation électrique continue 166.

La borne positive + de cette alimentation continue est reliée aux bornes C3 et C5 des interrupteurs 158 et 162 tandis que la borne négative - de cette alimentation continue est reliée aux bornes C4 et C6 des interrupteurs 160 et 164 comme on le voit sur la figure 8.

Pour faire fonctionner le pont onduleur et donc former les impulsions de mise en conduction et de blocage, on ferme les interrupteurs 158 et 164 (les interrupteurs 160 et 162 restant ouverts) pour appliquer une tension positive aux bornes du câble de commande 118 et donc engendrer un courant positif dans ce câble 118.

On ouvre ensuite ces interrupteurs 158 et 164 et, tout en laissant ceux-ci ouverts, on ferme les interrupteurs 160 et 162 pour appliquer une tension négative aux bornes du câble de commande 118 et engendrer un courant négatif dans ce câble de commande 118.

Ensuite on ouvre les interrupteurs 160 et 162.

Comme illustré sur la figure 7, une matrice 68 de transistors est connectée à une matrice de diodes 30 par une capacité 8. Les références 12, 13, 14, 18 et 20 ont les mêmes significations que sur les figures 1 et 3A-3C. Le dispositif de la figure 7 fonctionne comme le dispositif à un transistor et à une diode, de la manière décrite ci-dessus en liaison avec les figures 3A à 3C, mais il permet de générer de plus fortes tensions et de plus forts courants.

Les avantages du dispositif selon l'invention sont, en particulier :

- l'utilisation de composants standards,
- la possibilité de réalisation facile sur circuit imprimé,
- son faible coût,
- sa grande fiabilité,
- la possibilité de fonctionner à haute fréquence de récurrence,
- le faible jitter,
- l'adaptabilité du circuit :

  . au courant de charge :

    - par mise en matrice de diodes,

  . à la tension commutée :

    - par mise en matrice de transistors MOSFETs.

**Revendications**

1. Commutateur ultra-rapide, comportant :

   - un transistor MOSFET (4),
   - une diode (6) rapide à recouvrement inverse dur
   - un condensateur (8) connectant immédiatement l'onde de la diode et le drain du transistor,
   - des moyens (16, 18, 20, 22, 24) pour appliquer un courant direct ($I_1$) de polarisation de la diode égal au plus au 1/3 du courant inverse pouvant circuler lorsque le transistor est fermé.

2. Commutateur selon la revendication 1, les moyens pour appliquer un courant de polarisation à la diode comportant une alimentation de courant sous basse tension (18) et une inductance (20) en série.

3. Commutateur selon la revendication 1, les moyens pour appliquer un courant de polarisation à la diode comportant une inductance (22) et une résistance (24) en série placées parallèlement à la diode (6).

4. Commutateur ultra-rapide, comportant :

   - une matrice de transistors MOSFET,
   - une matrice (30) de diodes rapides,
   - un condensateur, situé entre les deux matrices,
   - des moyens pour appliquer un courant direct de polarisation des diodes égal au plus au 1/3 du courant inverse pouvant circuler lorsque les transistors sont fermés.

5. Commutateur selon la revendication 4, les moyens pour appliquer un courant de polarisation à la matrice de diodes comportant une alimentation de courant sous basse tension et une inductance en série.

6. Commutateur selon la revendication 4, les moyens pour appliquer un courant de polarisation à la matrice de diodes comportant une inductance et une résistance en série placées parallèlement à la matrice de diodes.

7. Commutateur selon l'une des revendications précédentes, le courant direct ($I_d$) de polarisation de la diode, ou des diodes, étant égal, au plus, au $1/10^è$ du courant inverse pouvant circuler lorsque le, ou les, transistor(s) est (sont) fermé(s).

**Patentansprüche**

1. Extrem schneller Schalter, umfassend:

   - einen MOSFET-Transistor (4),
   - eine schnelle Hard-Recovery-Diode (6),
   - einen Kondensator (8), der die Anode der Diode unmittelbar mit dem Drain des Transistors verbindet,
   - Einrichtungen (16, 18, 20, 22, 24) zum Anlegen bzw. Erzeugen eines Vorwärtsstroms ($I_1$) zur Polung der Diode von höchstens gleich 1/3 des Rückwärtsstroms, der fließen kann, wenn der Transistor gesperrt ist

2. Schalter nach Anspruch 1, wobei die Einrichtungen zum Anlegen eines Polungsstroms an die Diode eine Niederspannungs-Stromversorgung (18) und eine Induktanz (20) in Reihenschaltung umfassen.

3. Schalter nach Anspruch 1, wobei die Einrichtungen zum Anlegen eines Polungsstroms an die Diode eine Induktanz (22) und einen Widerstand (24) in Reihenschaltung umfassen, parallel zu der Diode (6) angeordnet.

4. Extrem schneller Schalter, umfassend:

   - eine Matrix aus MOSFET-Transistoren,
   - eine Matrix (30) aus schnellen Transistoren,
   - einen zwischen den beiden Matrizen befindlichen Kondensator,
   - Einrichtungen zum Anlegen bzw. Erzeugen eines Vorwärtsstroms zur Polung. der Dioden von höchstens gleich 1/3 des Rückwärtsstroms, der fließen kann, wenn die Transistoren gesperrt sind.

5. Schalter nach Anspruch 4, wobei die Einrichtungen zum Anlegen eines Polungsstroms an die Diodenmatrix eine Niederspannungs-Stromversorgung und eine Induktanz in Reihenschaltung umfassen.

6. Schalter nach Anspruch 4, wobei die Einrichtungen zum Anlegen eines Polungsstroms an die Diodenmatrix eine Induktanz und einen Widerstand in Reihenschaltung umfassen, parallel zu der Diodenmatrix angeordnet.

7. Schalter nach den vorangehenden Ansprüchen, wobei der Vorwärtsstrom ($I_d$) zur Polung der Diode, oder der Dioden, höchstens gleich 1/10 des Rückwärtsstroms ist, der fließen kann, wenn der (die) Transistor(en) geschlossen ist (sind).

**Claims**

1.  Ultra-fast switch, comprising:

    -   a MOSFET transistor (4),
    -   a hard-recovery fast diode (6),
    -   a capacitor (8) immediately connecting the anode of the diode and the drain of the transistor,
    -   means (16, 18, 20, 22, 24) for applying a forward bias current ($I_1$) for biasing the diode, equal to at most 1/3 of the reverse current that can flow when the transistor is closed.

2.  Switch according to Claim 1, the means for applying a bias current to the diode comprising a low-voltage current supply (18) and an inductor (20) in series.

3.  Switch according to Claim 1, the means for applying a bias current to the diode comprising an inductor (22) and a resistor (24) in series that are placed in parallel with the diode (6).

4.  Ultra-fast switch, comprising:

    -   a matrix of MOSFET transistors,
    -   a matrix (30) of fast diodes,
    -   a capacitor, situated between the two matrices,
    -   means for applying a forward bias current for biasing the diodes, equal to at most 1/3 of the reverse current that can flow when the transistors are closed.

5.  Switch according to Claim 4, the means for applying a bias current to the matrix of diodes comprising a low-voltage current supply and an inductor in series.

6.  Switch according to Claim 4, the means for applying a bias current to the matrix of diodes comprising an inductor and a resistor in series that are placed in parallel with the matrix of diodes.

7.  Switch according to one of the preceding claims, the forward bias current ($I_d$) for biasing the diode or diodes, being equal, at most, to $1/10^{th}$ of the reverse current that can flow when the transistor or transistors is (are) closed.

FIG. 1

FIG. 2A

FIG. 2B

FIG. 3A

FIG. 3B

FIG. 3C

FIG. 4

FIG. 6

FIG. 5

FIG. 7

EP 0 887 929 B1

FIG. 8